# EUROPÄISCHE PATENTSCHRIFT

(11) **EP 3 622 619 B1**
(45) Veröffentlichungstag und Bekanntmachung des Hinweises auf die Patenterteilung: **17.02.2021**
(21) Anmeldenummer: 17739947.4
(22) Anmeldetag: 07.07.2017
(51) Int. Cl.: H02M 1/32, H02H 7/12, H02M 7/483, H01H 79/00

(54) **ELEKTRISCHE KURZSCHLIESSEINRICHTUNG**
ELECTRIC SHORT-CIRCUIT DEVICE
DISPOSITIF DE COURT-CIRCUIT ÉLECTRIQUE

(43) Veröffentlichungstag der Anmeldung: 18.03.2020
(73) Patentinhaber: Siemens Energy Global GmbH & Co. KG, 81739 München (DE)
(72) Erfinder: STAHLHUT, Nils, 91341 Röttenbach (DE)
(86) Internationale Anmeldenummer: PCT/EP2017/067105
(87) Internationale Veröffentlichungsnummer: WO 2019/007532

(56) Entgegenhaltungen:
- DE-U1-202014 104 564
- DATABASE WPI Week 198818 Thomson Scientific, London, GB; AN 1988-124943 XP002779153, -& SU 1 341 690 A (KAMSHNYI A N) 4. März 1987 (1987-03-04)
- DATABASE WPI Week 201360 Thomson Scientific, London, GB; AN 2013-M77476 XP002779154, -& JP 2013 169088 A (HITACHI LTD) 29. August 2013 (2013-08-29)
- GUANJUN DING ET AL: "New technologies of voltage source converter (VSC) for HVDC transmission system based on VSC", POWER AND ENERGY SOCIETY GENERAL MEETING - CONVERSION AND DELIVERY OF ELECTRICAL ENERGY IN THE 21ST CENTURY, 2008 IEEE, IEEE, PISCATAWAY, NJ, USA, 20. Juli 2008 (2008-07-20), Seiten 1-8, XP031304187, ISBN: 978-1-4244-1905-0

## Beschreibung

Die Erfindung betrifft eine elektrische Kurzschließeinrichtung. Bei elektrischen Schaltungen besteht manchmal die Notwendigkeit, bestimmte Schaltungsteile kurzzuschließen (zu überbrücken). Beispielsweise gibt es Stromrichter, welche eine Vielzahl von elektrischen Modulen in einer Reihenschaltung aufweisen. Wenn eines der Module beim Betrieb kaputt geht, dann ist es wünschenswert, dieses defekte Modul kurzzuschließen (zu überbrücken), damit die übrigen Module der elektrischen Reihenschaltung weiterbetrieben werden können

Die Patentschrift SU 1341690 A1 beschreibt eine elektrische Kurzschließeinrichtung, die einen Thyristor in Form eines SiliziumEinkristalls aufweist, wobei die Kristallstruktur durch eine Überspannung zerstört wird.

Das Dokument DE 20 2014 104 564 U1 zeigt einen Kursschlussschalter mit einem Thyristor vom Press-Pack-Typ.

Aus der internationalen Patentanmeldung WO 2011/107363 A1 ist eine elektrische Kurzschließeinrichtung mit einem pyrotechnischen Antrieb bekannt. Der pyrotechnische Antrieb ermöglicht ein schnelles Schließen der Kurzschließeinrichtung, verursacht aber manchmal Probleme in Bezug auf die Sicherheit (Explosivstoff).

Der Erfindung liegt die Aufgabe zugrunde, eine Kurzschließeinrichtung und ein Verfahren zum Kurzschließen eines Moduls als Reaktion auf ein elektrisches Auslösesignal anzugeben, bei denen kein pyrotechnischer Antrieb benötigt wird.

Diese Aufgabe wird erfindungsgemäß gelöst durch eine elektrische Kurzschließeinrichtung und durch ein Verfahren nach den unabhängigen Patentansprüchen. Vorteilhafte Ausführungsformen der Kurzschließeinrichtung und des Verfahrens sind in den abhängigen Patentansprüchen angegeben.

Offenbart wird eine elektrische Kurzschließeinrichtung (Überbrückungseinrichtung)
- mit einem ersten elektrischen Kontaktstück und einem zweiten elektrischen Kontaktstück,
- mit einem Bauteil aus einem elektrisch halbleitenden kristallinen Material, das einen elektrischen Stromfluss zwischen dem ersten Kontaktstück und dem zweiten Kontaktstück in mindestens einer Richtung sperrt und
- mit einem (elektrischen) Aktor (Antriebselement), der dazu eingerichtet ist, auf ein elektrisches Auslösesignal hin das Bauteil mit einer mechanischen Kraft zu beaufschlagen und dadurch die Kristallstruktur des Bauteils zumindest teilweise zu zerstören. Der Aktor kann auch dazu eingerichtet sein, auf das elektrische Auslösesignal hin das Bauteil mit einer mechanischen Kraft zu beaufschlagen und dadurch das Material zu zerbrechen. Aufgrund der zumindest teilweise zerstörten Kristallstruktur des halbleitenden kristallinen Materials verliert dieses Material seine elektrische Sperrfähigkeit, so dass daraufhin ein elektrischer Stromfluss zwischen dem ersten Kontaktstück und dem zweiten Kontaktstück in der ursprünglich gesperrten Richtung ermöglicht ist. Dieser Vorgang wird auch als Durchlegieren bezeichnet. Bereits feine Risse oder Brüche in der Kristallstruktur des kristallinen Materials können ausreichen, um die elektrischen Sperreigenschaften der Kurzschließeinrichtung aufzuheben. Natürlich ist es aber auch möglich, mittels der mechanischen Kraft das halbleitende kristalline Material in mehrere (mit dem bloßen Auge sichtbare) Bruchstücke zu zerbrechen. Allgemein ist der Aktor ein Element, das ein elektrisches Signal in eine mechanische Bewegung umsetzt.

Die Kurzschließeinrichtung kann so ausgestaltet sein, dass das Bauteil zwischen dem ersten Kontaktstück und dem zweiten Kontaktstück angeordnet ist. Insbesondere kann das Bauteil zwischen dem ersten Kontaktstück und dem zweiten Kontaktstück eingespannt sein. Der elektrische Strom fließt im kurzgeschlossenen Zustand vorteilhafterweise von einem der Kontaktstücke durch das Bauteil zu dem anderen der Kontaktstücke, je nach Richtung des Stroms.

Die Kurzschließeinrichtung kann so ausgestaltet sein, dass die Kurzschließeinrichtung als Scheibenzelle ausgestaltet ist. Dadurch kann die Kurzschließeinrichtung mechanisch sehr kompakt und robust ausgestaltet sein. Dabei sind das erste Kontaktstück und das zweite Kontaktstück im Wesentlichen parallel zueinander ausgerichtet.

Die Kurzschließeinrichtung kann auch so ausgestaltet sein, dass das erste Kontaktstück eine erste Ausnehmung aufweist, in der der Aktor angeordnet ist. Der in der ersten Ausnehmung ungeordnete Aktor kann unmittelbar mechanisch auf das Bauteil einwirken.

Die Kurzschließeinrichtung kann auch so ausgestaltet sein, dass das zweite Kontaktstück eine zweite Ausnehmung aufweist, die gegenüberliegend zur ersten Ausnehmung angeordnet ist. Die zweite Ausnehmung ermöglicht dem Bauteil, sich auf die mechanische Kraft hin zu verformen. Dadurch wird bewirkt, dass auf die mechanische Kraft hin die Kristallstruktur des Bauteils teilweise zerstört wird.

Die Kurzschließeinrichtung kann so ausgestaltet sein, dass das Bauteil die erste Ausnehmung von der zweiten Ausnehmung trennt.

Die Kurzschließeinrichtung kann auch so ausgestaltet sein, dass das Bauteil eine Scheibe (aus dem elektrisch halbleitenden kristallinen Material) ist. Eine derartige Scheibe wird auch als Wafer bezeichnet. Da derartige Scheiben vergleichsweise dünn hergestellt werden können, ist es möglich, die Kristallstruktur des kristallinen Materials mit einem vergleichsweise kleinen Aktor und/oder einem geringen elektrischen Auslösesignal zu zerstören.

Die Kurzschließeinrichtung kann so ausgestaltet sein, dass das Bauteil mindestens einen p-n-Übergang, insbesondere zwei einander entgegengesetzt gerichtete p-n-Übergänge, aufweist.

Wenn das Bauteil nur einen p-n-Übergang aufweist (wenn das Bauteil also beispielsweise einer elektrischen Diode entspricht), dann ist es in der Lage, im nicht kurzschließenden Zustand den elektrischen Strom in einer Richtung zu sperren. Wenn das Bauteil zwei einander entgegengesetzt gerichtete p-n-Übergänge aufweist (wenn das Bauteil also beispielsweise einem Thyristor entspricht), dann ist das Bauteil in der Lage, im nicht kurzschließenden Zustand den elektrischen Strom in beiden Richtungen zu sperren.

Die Kurzschließeinrichtung kann auch so ausgestaltet sein, dass der mindestens eine p-n-Übergang ein flächiger p-n-Übergang ist, der parallel zu dem ersten elektrischen Kontaktstück und/oder parallel zu dem zweiten elektrischen Kontaktstück ausgerichtet ist. Mittels eines oder mehrerer derartiger flächiger p-n-Übergänge lassen sich im kurzschließenden Zustand der Kurzschließeinrichtung auch große elektrische Ströme sicher leiten.

Die Kurzschließeinrichtung kann auch so ausgestaltet sein, dass der Aktor ein (elektrischer) Piezoaktor ist. Ein derartiger Piezoaktor hat insbesondere den Vorteil, dass er auf das elektrische Auslösesignal hin sehr schnell eine mechanische Bewegung erzeugt und daher in der Lage ist, auf das elektrische Auslösesignal hin das Bauteil sehr schnell mit der mechanischen Kraft zu beaufschlagen.

Die Kurzschließeinrichtung kann auch so ausgestaltet sein, dass
- das Bauteil ein elektrisch einschaltbares Halbleiterbauelement (insbesondere ein Thyristor) ist, dessen Steueranschluss (insbesondere dessen Gate-Anschluss) aus der Kurzschließeinrichtung herausgeführt ist, so dass das Halbleiterbauelement auch mittels seines Steueranschlusses (elektrisch) eingeschaltet werden kann.

Offenbart wird weiterhin ein Stromrichter mit einer Mehrzahl von (gleichartigen) zweipoligen Modulen (Submodulen), welche elektrisch in Reihe geschaltet sind, wobei jedem der Module jeweils eine elektrische Kurzschließeinrichtung nach einer der vorstehend beschriebenen Varianten zugeordnet (insbesondere parallel geschaltet) ist (so dass die Module mittels der ihnen jeweils zugeordneten Kurzschließeinrichtung kurzschließbar (überbrückbar) sind).

Dieser Stromrichter kann insbesondere ein modularer Multilevelstromrichter sein.

Offenbart wird weiterhin ein Verfahren zum Kurzschließen eines elektrischen zweipoligen Moduls, wobei parallel zu dem Modul eine elektrische Kurzschließeinrichtung geschaltet ist, die ein erstes elektrisches Kontaktstück, ein zweites elektrisches Kontaktstück und ein Bauteil aus einem elektrisch halbleitenden kristallinen Material aufweist, wobei bei dem Verfahren
- von dem Bauteil zunächst ein elektrischer Stromfluss zwischen dem ersten Kontaktstück und dem zweiten Kontaktstück in mindestens einer Richtung gesperrt wird,
- auf ein elektrisches Auslösesignal hin das Bauteil von einem Aktor mit einer mechanischen Kraft beaufschlagt wird, und
- dadurch die Kristallstruktur des Bauteils zumindest teilweise (mechanisch)] zerstört wird, wodurch (das Bauteil durchlegiert und) der elektrische Stromfluss zwischen dem ersten elektrischen Kontaktstück und dem zweiten elektrischen Kontaktstück in der ursprünglich gesperrten Richtung ermöglicht wird.

Dieses Verfahren kann so ausgestaltet sein, dass das elektrische Modul mindestens zwei elektronische Schaltelemente und einen elektrischen Energiespeicher aufweist.

Das Verfahren kann auch so ausgestaltet sein, dass das elektrische Modul ein Modul (Submodul) eines modularen Multilevelstromrichters ist.

Das Verfahren kann auch so ausgestaltet sein, dass das Bauteil eine Scheibe (aus dem elektrisch halbleitenden kristallinen Material) ist.

Das Verfahren kann so ausgestaltet sein, dass der Aktor ein (elektrischer) Piezoaktor ist.

Das Verfahren weist gleichartige Vorteile auf, wie sie oben in Zusammenhang mit der Kurzschließeinrichtung dargestellt sind.

Im Folgenden wird die Erfindung anhand von Ausführungsbeispielen näher erläutert. Gleiche Bezugszeichen verweisen dabei auf gleiche oder gleich wirkende Elemente. Dazu ist in
- Figur 1: ein Ausführungsbeispiel eines Stromrichters, der eine Vielzahl von Modulen aufweist, in
- Figur 2: ein Ausführungsbeispiel eines Moduls mit einer Kurzschließeinrichtung, in
- Figur 3: ein weiteres Ausführungsbeispiel eines Moduls mit einer Kurzschließeinrichtung, in
- Figur 4: ein Ausführungsbeispiel einer Kurzschließeinrichtung in einer dreidimensionalen Darstellung, in
- Figur 5: das Ausführungsbeispiel der Kurzschließeinrichtung in einer Draufsicht, in
- Figur 6: das Ausführungsbeispiel der Kurzschließeinrichtung in einer Schnittdarstellung, in
- Figur 7: das Ausführungsbeispiel der Kurzschließeinrichtung nach dem Auslösesignal in einer Schnittdarstellung, in
- Figur 8: ein Ausführungsbeispiel eines Bauteils aus einem elektrisch halbleitenden Material, und in
- Figur 9: ein beispielhaftes Schaltzeichen für die Kurzschließeinrichtung
dargestellt.

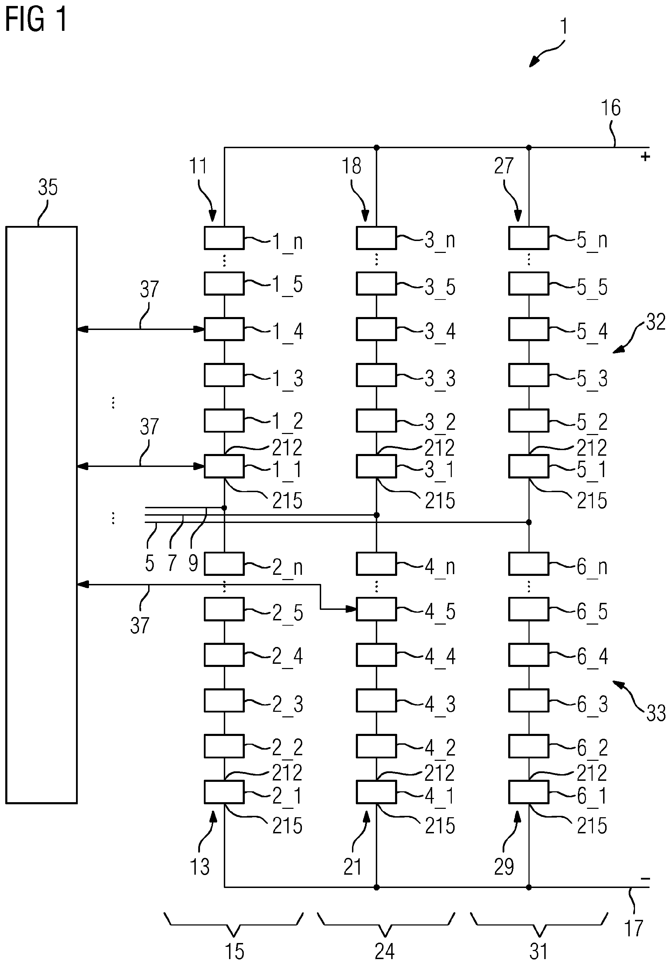

In Figur 1 ist ein Stromrichter 1 in Form eines modularen Multilevelstromrichters 1 (modular multilevel converter, MMC) dargestellt. Dieser Multilevelstromrichter 1 weist einen ersten Wechselspannungsanschluss 5, einen zweiten Wechselspannungsanschluss 7 und einen dritten Wechselspannungsanschluss 9 auf. Der erste Wechselspannungsanschluss 5 ist elektrisch mit einem ersten Phasenmodulzweig 11 und einem zweiten Phasenmodulzweig 13 verbunden. Der erste Phasenmodulzweig 11 und der zweite Phasenmodulzweig 13 bilden ein erstes Phasenmodul 15 des Stromrichters 1. Das dem ersten Wechselspannungsanschluss 5 abgewandte Ende des ersten Phasenmodulzweigs 11 ist mit einem ersten Gleichspannungsanschluss 16 elektrisch verbunden; das dem ersten Wechselspannungsanschluss 5 abgewandte Ende des zweiten Phasenmodulzweigs 13 ist mit einem zweiten Gleichspannungsanschluss 17 elektrisch verbunden. Der erste Gleichspannungsanschluss 16 ist ein positiver Gleichspannungsanschluss; der zweite Gleichspannungsanschluss 17 ist ein negativer Gleichspannungsanschluss.

Der zweite Wechselspannungsanschluss 7 ist mit einem Ende eines dritten Phasenmodulzweigs 18 und mit einem Ende eines vierten Phasenmodulzweigs 21 elektrisch verbunden. Der dritte Phasenmodulzweig 18 und der vierte Phasenmodulzweig 21 bilden ein zweites Phasenmodul 24. Der dritte Wechselspannungsanschluss 9 ist mit einem Ende eines fünften Phasenmodulzweigs 27 und mit einem Ende eines sechsten Phasenmodulzweigs 29 elektrisch verbunden. Der fünfte Phasenmodulzweig 27 und der sechste Phasenmodulzweig 29 bilden ein drittes Phasenmodul 31.

Das dem zweiten Wechselspannungsanschluss 7 abgewandte Ende des dritten Phasenmodulzweigs 18 und das dem dritten Wechselspannungsanschluss 9 abgewandte Ende des fünften Phasenmodulzweigs 27 sind mit dem ersten Gleichspannungsanschluss 16 elektrisch verbunden. Das dem zweiten Wechselspannungsanschluss 7 abgewandte Ende des vierten Phasenmodulzweigs 21 und das dem dritten Wechselspannungsanschluss 9 abgewandte Ende des sechsten Phasenmodulzweigs 29 sind mit dem zweiten Gleichspannungsanschluss 17 elektrisch verbunden. Der erste Phasenmodulzweig 11, der dritte Phasenmodulzweig 18 und der fünfte Phasenmodulzweig 27 bilden ein positivseitiges Stromrichterteil 32; der zweite Phasenmodulzweig 13, der vierte Phasenmodulzweig 21 und der sechste Phasenmodulzweig 29 bilden ein negativseitiges Stromrichterteil 33.

Jeder Phasenmodulzweig weist eine Mehrzahl von Modulen (1_1, 1_2, 1_3, 1_4 ... 1_n; 2_1 ... 2 n; usw.) auf, welche (mittels ihrer galvanischen Stromanschlüsse) elektrisch in Reihe geschaltet sind. Solche Module werden auch als Submodule bezeichnet. Im Ausführungsbeispiel der Figur 1 weist jeder Phasenmodulzweig n Module auf. Die Anzahl der mittels ihrer galvanischen Stromanschlüsse elektrisch in Reihe geschalteten Module kann sehr verschieden sein, mindestens sind drei Module in Reihe geschaltet, es können aber auch beispielsweise 50, 100 oder mehr Module elektrisch in Reihe geschaltet sein. Im Ausführungsbeispiel ist n = 36: der erste Phasenmodulzweig 11 weist also 36 Module 1_1, 1_2, 1_3, ... 1_36 auf. Die anderen Phasenmodulzweige 13, 18, 21, 27 und 29 sind gleichartig aufgebaut.

Im linken Bereich der Figur 1 ist schematisch eine Steuereinrichtung 35 für die Module 1_1 bis 6_n dargestellt. Von dieser zentralen Steuereinrichtung 35 werden optische Nachrichten bzw. optische Signale über eine optische Kommunikationsverbindung 37 (zum Beispiel über einen Lichtwellenleiter) zu den einzelnen Modulen übertragen. Die Nachrichtenübertragung zwischen der Steuereinrichtung und einem Modul ist jeweils symbolhaft durch eine Linie 37 dargestellt; die Richtung der Nachrichtenübertragung ist durch die Pfeilspitzen an den Linien 37 symbolisiert. Dies ist am Beispiel der Module 1_1, 1_4 und 4_5 dargestellt; zu den anderen Modulen werden auf die gleiche Art und Weise Nachrichten gesendet beziehungsweise von diesen Modulen Nachrichten empfangen. Beispielsweise sendet die Steuereinrichtung 35 an die einzelnen Module jeweils einen Sollwert zur Höhe der Ausgangsspannung, die das jeweilige Modul bereitstellen soll.

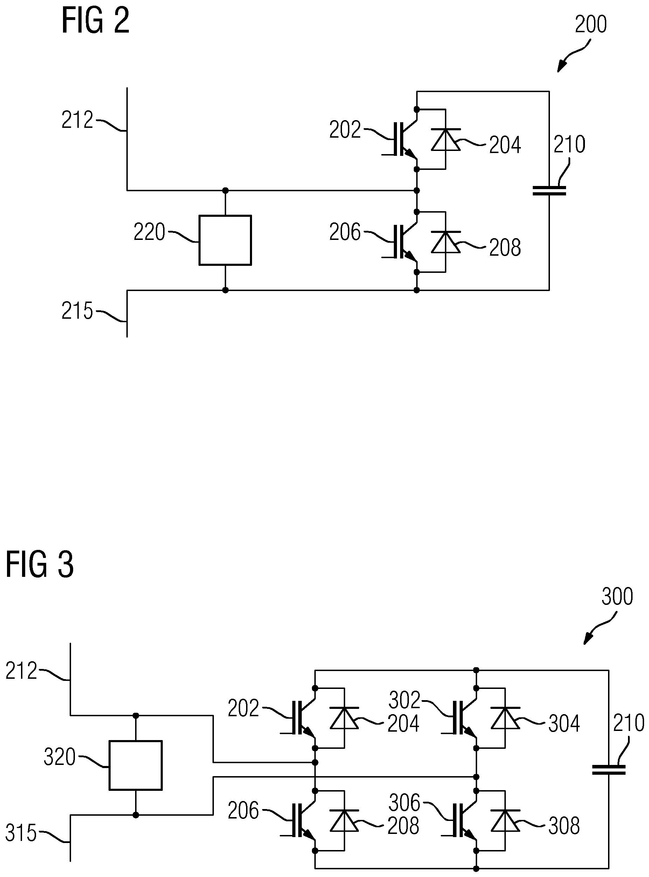

In Figur 2 ist ein Ausführungsbeispiel eines Moduls 200 des Stromrichters 1 dargestellt. Dabei kann es sich beispielsweise um eines der in Figur 1 dargestellten Module 1_1 ... 6_n handeln.

Das Modul 200 ist als ein Halbbrücken-Modul 200 ausgestaltet. Das Modul 200 weist ein erstes (abschaltbares) elektronisches Schaltelement 202 (erstes abschaltbares Halbleiterventil 202) mit einer ersten antiparallel geschalteten Diode 204 auf. Weiterhin weist das Modul 200 ein zweites (abschaltbares) elektronisches Schaltelement 206 (zweites abschaltbares Halbleiterventil 206) mit einer zweiten antiparallel geschalteten Diode 208 sowie einen elektrischen Energiespeicher 210 in Form eines Kondensators 210 auf. Das erste elektronische Schaltelement 202 und das zweite elektronische Schaltelement 206 sind jeweils als ein IGBT (insulated-gate bipolar transistor) ausgestaltet. Das erste elektronische Schaltelement 202 ist elektrisch in Reihe geschaltet mit dem zweiten elektronischen Schaltelement 206. Am Verbindungspunkt zwischen den beiden elektronischen Schaltelementen 202 und 206 ist ein erster galvanischer Modulanschluss 212 angeordnet. An dem Anschluss des zweiten elektronischen Schaltelements 206, welcher dem Verbindungspunkt gegenüberliegt, ist ein zweiter galvanischer Modulanschluss 215 angeordnet. Der zweite Modulanschluss 215 ist weiterhin mit einem ersten Anschluss des Energiespeichers 210 elektrisch verbunden; ein zweiter Anschluss des Energiespeichers 210 ist elektrisch verbunden mit dem Anschluss des ersten elektronischen Schaltelements 202, der dem Verbindungspunkt gegenüberliegt.

Der Energiespeicher 210 ist also elektrisch parallel geschaltet zu der Reihenschaltung aus dem ersten elektronischen Schaltelement 202 und dem zweiten elektronischen Schaltelement 206. Durch entsprechende Ansteuerung des ersten elektronischen Schaltelements 202 und des zweiten elektronischen Schaltelements 206 durch eine (nicht dargestellte) elektronische Steuereinrichtung des Stromrichters kann erreicht werden, dass zwischen dem ersten Modulanschluss 212 und dem zweiten Modulanschluss 215 entweder die Spannung des Energiespeichers 210 ausgegeben wird oder keine Spannung ausgegeben wird (d.h. eine Nullspannung ausgegeben wird). Durch Zusammenwirken der Module der einzelnen Phasenmodulzweige kann so die jeweils gewünschte Ausgangsspannung des Stromrichters erzeugt werden.

Parallel zu dem Modul 200 ist eine Kurzschließeinrichtung 220 geschaltet. Die Kurzschließeinrichtung 220 ist also zwischen den ersten Modulanschluss 212 und den zweiten Modulanschluss 215 geschaltet. Wenn die Kurzschließeinrichtung 220 in den kurzgeschlossenen Zustand / kurzschließenden Zustand übergeht, dann überbrückt die Kurzschließeinrichtung 220 das Modul 200; die Kurzschließeinrichtung 220 schließt das Modul 200 kurz. Der Betriebsstrom des Stromrichters fließt dann beispielsweise vom ersten Modulanschluss 212 über die Kurzschließeinrichtung 220 zum zweiten Modulanschluss 215 (und nicht über die übrigen Bauelemente des Moduls 200, insbesondere nicht über die Schaltelemente 202, 206 und die Dioden 204, 208).

In Figur 3 ist ein weiteres Ausführungsbeispiel eines Moduls 300 des Stromrichters 1 dargestellt. Dabei kann es sich beispielsweise um eines der in Figur 1 dargestellten Module 1_1 ... 6_n handeln. Neben den bereits aus Figur 2 bekannten ersten elektronischen Schaltelement 202, zweiten elektronischen Schaltelement 206, erster Freilaufdiode 204, zweiter Freilaufdiode 208 und Energiespeicher 210 weist das in Figur 3 dargestellte Modul 300 ein drittes elektronisches Schaltelement 302 mit einer antiparallel geschalteten dritten Freilaufiode 304 sowie ein viertes elektronisches Schaltelement 306 mit einer vierten antiparallel geschalteten Freilaufdiode 308 auf. Das dritte elektronische Schaltelement 302 und das vierte elektronische Schaltelement 306 sind jeweils als ein IGBT ausgestaltet. Im Unterschied zur Schaltung der Figur 2 ist der zweite Modulanschluss 315 nicht mit dem zweiten elektronischen Schaltelement 206 elektrisch verbunden, sondern mit einem Mittelpunkt einer elektrischen Reihenschaltung aus dem dritten elektronischen Schaltelement 302 und dem vierten elektronischen Schaltelement 306.

Das Modul 300 der Figur 3 ist ein sogenanntes Vollbrücken-Modul 300. Dieses Vollbrücken-Modul 300 zeichnet sich dadurch aus, dass bei entsprechender Ansteuerung der vier elektronischen Schaltelemente zwischen dem ersten (galvanischen) Modulanschluss 212 und dem zweiten (galvanischen) Modulanschluss 315 wahlweise entweder die positive Spannung des Energiespeichers 210, die negative Spannung des Energiespeichers 210 oder eine Spannung des Wertes Null (Nullspannung) ausgegeben werden kann. Somit kann also mittels des Vollbrückenmoduls 300 die Polarität der Ausgangsspannung umgekehrt werden. Der Multilevelstromrichter 1 kann entweder nur Halbbrücken-Module 200, nur Vollbrücken-Module 300 oder auch Halbbrücken-Module 200 und Vollbrücken-Module 300 aufweisen.

Parallel zu dem Modul 300 ist eine Kurzschließeinrichtung 320 geschaltet. Die Kurzschließeinrichtung 320 ist also zwischen den ersten Modulanschluss 212 und den zweiten Modulanschluss 315 geschaltet. Wenn die Kurzschließeinrichtung 320 in den kurzgeschlossenen Zustand / kurzschließenden Zustand übergeht, dann überbrückt die Kurzschließeinrichtung 320 das Modul 300; die Kurzschließeinrichtung 320 schließt das Modul 300 kurz. Der Betriebsstrom des Stromrichters fließt dann beispielsweise vom ersten Modulanschluss 212 über die Kurzschließeinrichtung 320 zum zweiten Modulanschluss 315 (und nicht über die übrigen Bauelemente des Moduls 300, insbesondere nicht über die Schaltelemente 202, 206, 302, 306 und/oder die Dioden 204, 208, 304, 308). Die Kurzschließeinrichtung 320 kann wie die Kurzschließeinrichtung 220 aufgebaut sein.

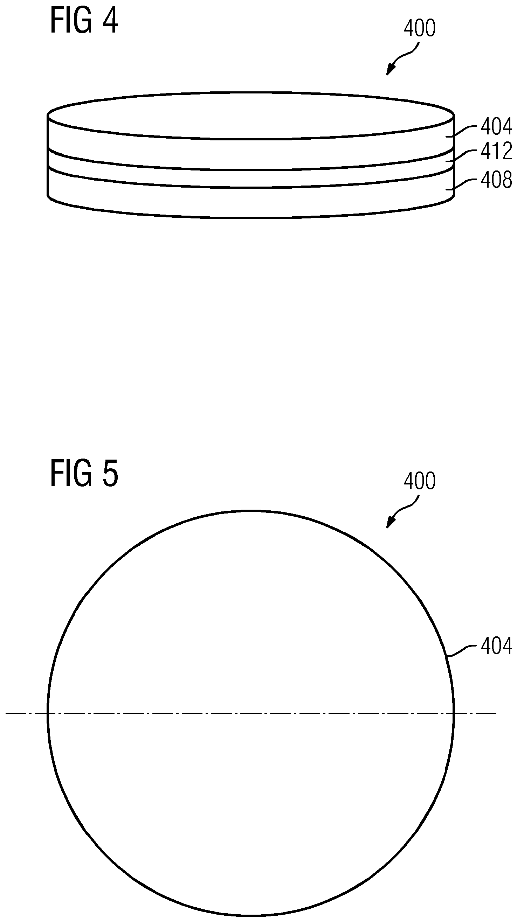

In Figur 4 ist schematisch eine äußere Ansicht eines Ausführungsbeispiels einer Kurzschließeinrichtung 400 dargestellt. Bei dieser Kurzschließeinrichtung 400 kann es sich beispielsweise um die Kurzschließeinrichtung 220 oder die Kurzschließeinrichtung 320 handeln.

Die Kurzschließeinrichtung 400 hat im Wesentlichen die äußere Form eines geraden Kreiszylinders mit vergleichsweise geringer Höhe, also die Form einer sogenannten Scheibenzelle 400. Schematisch sind ein erstes elektrisches Kontaktstück 404, ein zweites elektrisches Kontaktstück 408, sowie ein zwischen dem ersten elektrischen Kontaktstück 404 und dem zweiten elektrischen Kontaktstück 408 angeordnetes Bauteil 412 aus einem elektrisch halbleitenden kristallinen Material angedeutet.

Das erste elektrische Kontaktstück 404 kann als ein erstes Druckstück 404 ausgestaltet sein; das zweite elektrische Kontaktstück 408 kann als ein zweites Druckstück 408 ausgestaltet sein. Das Bauteil 412 kann zwischen dem ersten Druckstück 404 und dem zweiten Druckstück 408 verspannt/eingespannt sein. Das erste elektrische Kontaktstück 404 und das zweite elektrische Kontaktstück 408 können aus einem Metall bestehen, beispielsweise aus Kupfer.

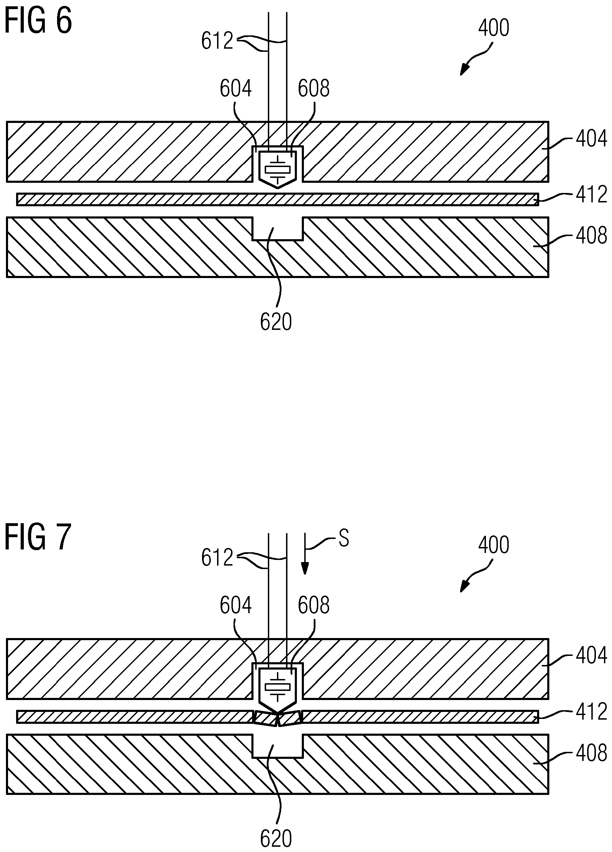

In Figur 5 ist schematisch eine Draufsicht auf die Kurzschließeinrichtung 400 dargestellt. In Figur 5 ist mittels einer Strich-Punkt-Linie ein Schnitt entlang des Durchmessers der Kurzschließeinrichtung 400 angedeutet. Die zugehörigen Schnittdarstellungen sind in den Figuren 6 und 7 gezeigt.

In Figur 6 ist schematisch eine Schnittdarstellung durch die Kurzschließeinrichtung 400 im nichtkurzgeschlossenen Zustand dargestellt. Dieser nichtkurzgeschlossene Zustand (nichtkurzschließende Zustand) entspricht einem offenen Schalter. Das erste Kontaktstück 404 und das zweite Kontaktstück 408 weisen jeweils die Grundform eines geraden Kreiszylinders auf. Das erste Kontaktstück 404 weist eine erste Ausnehmung 604 auf, in der ein Aktor 608 angeordnet ist. Die erste Ausnehmung 604 ist eine zentrische Ausnehmung 604. Im Ausführungsbeispiel ist die erste Ausnehmung 604 rotationssymmetrisch ausgestaltet.

Der Aktor 608 setzt ein elektrisches Signal (Auslösesignal) in eine mechanische Bewegung um. Mittels der mechanischen Bewegung ist der Aktor 608 in der Lage, das Bauteil 412 mit einer mechanischen Kraft zu beaufschlagen. Der Aktor 608 weist zwei Anschlüsse 612 auf, über die das elektrische Auslösesignal dem Aktor 608 zugeführt wird. Im Ausführungsbeispiel handelt es sich bei dem Aktor um einen Piezoaktor 608. Dieser Piezoaktor 608 setzt mittels eines piezoelektrischen Kristalls das Signal in eine mechanische Bewegung um. Dadurch wird die Kraft auf das Bauteil 412 aufgebracht. In dem schematisch dargestellten Aktor 608 ist der piezoelektrische Kristall angedeutet.

In dem zweiten Kontaktstück 408 ist eine zweite Ausnehmung 620 angeordnet. Diese zweite Ausnehmung 620 ist gegenüberliegend zur ersten Ausnehmung 604 angeordnet. Das Bauteil 412 ist zwischen dem ersten Kontaktstück 404 und dem zweiten Kontaktstück 408 angeordnet. Dabei trennt das Bauteil 412 die erste Ausnehmung 604 von der zweiten Ausnehmung 620. Das Bauteil 412 ist im Ausführungsbeispiel eine Scheibe aus einem elektrisch halbleitenden, kristallinen Material.

Im Ausführungsbeispiel sind die erste Ausnehmung 604 und die zweite Ausnehmung 620 komplementär zueinander ausgestaltet. Die zweite Ausnehmung 620 stellt eine Expansions-Ausnehmung (beispielsweise eine Expansionskammer) dar. Diese zweite Ausnehmung 620 ermöglicht es, dass auf die mechanische Kraft hin das Bauteil 412 mechanisch (in Richtung der zweiten Ausnehmung 620) verformt wird und dadurch die Kristallstruktur des Bauteils 412 zumindest teilweise (insbesondere zumindest örtlich) zerstört wird.

In Figur 7 ist schematisch die Kurzschließeinrichtung 400 in dem kurzschließenden Zustand dargestellt. Auf ein elektrisches Auslösesignal S hin hat der Aktor 608 das Bauteil 412 mit einer mechanischen Kraft beaufschlagt. Durch die Kraft ist das Bauteil 412 in Richtung der zweiten Ausnehmung 620 durchgebogen worden, daraufhin ist das Bauteil 412 zerbrochen. Dieses Zerbrechen des Bauteils 412 ist in Figur 7 grob und schematisch dargestellt. Es ist völlig ausreichend, wenn durch die Beaufschlagung mit der Kraft sich in der Kristallstruktur des Bauteils 412 feine Risse bilden und dadurch die Kristallstruktur des Bauteils zumindest teilweise zerstört wird.

Durch diese Zerstörung der Kristallstruktur des Bauteils ist das Bauteil 412 nicht mehr in der Lage, den elektrischen Stromfluss zu sperren und der elektrische Strom kann nun beispielsweise von dem ersten Kontaktstück 404 über das Bauteil 412 zu dem zweiten Kontaktstück 408 fließen. Das elektrisch halbleitende, kristalline Material des Bauteils 412 wird mit Ladungsträgern überschwemmt und dadurch leitend. Dieser Vorgang wird auch als Durchlegieren bezeichnet. Dadurch wird das erste Kontaktstück 404 mit dem zweiten Kontaktstück 408 kurzgeschlossen, und die elektrische Kurzschließeinrichtung 400 befindet sich in ihrem kurzgeschlossenen (kurzschließenden) Zustand.

Mit anderen Worten gesagt, ist die Kraftwirkung des Aktors 608 auf das Bauteil 412 gerichtet. Zum Einschalten der Kurzschließeinrichtung 400 wird der Aktor 608 mit dem elektrischen Auslösesignal S (beispielsweise mit einem Spannungsimpuls) beaufschlagt. Die dadurch entstehende Kraftwirkung des Aktors 608 wirkt auf das Bauteil 412 ein, drückt das Bauteil in die zweite Ausnehmung 620 und bricht dadurch das Bauteil 412. Durch den entstehenden Bruch im Kristallgefüge verliert das Bauteil 412 seine Sperr- bzw. Blockier-Eigenschaften und sorgt für einen sicheren Kurzschluss zwischen erstem Kontaktstück 404 und dem zweiten Kontaktstück 408 (das Bauteil 412 legiert durch).

Es wird darauf hingewiesen, dass in den Figuren 6 und 7 aus Gründen der besseren Erkennbarkeit ein Abstand zwischen dem ersten Kontaktstück 404 und dem Bauteil 412 sowie zwischen dem Bauteil 412 und dem zweiten Kontaktstück 408 dargestellt ist. Dieser Abstand ist jedoch nur aus Gründen der besseren Übersichtlichkeit enthalten. In der Realität ist bei einer fertig montierten Kurzschließeinrichtung in der Regel kein derartig großer Abstand zwischen dem ersten Kontaktstück 404 und dem Bauteil 412 und zwischen dem Bauteil 412 und dem zweiten Kontaktstück 408 vorhanden. Vielmehr ist das Bauteil 412 zwischen dem ersten Kontaktstück 404 und dem zweiten Kontaktstück 408 eingespannt; das Bauteil 412 wird von den Kontaktstücken 404 und 408 gehalten.

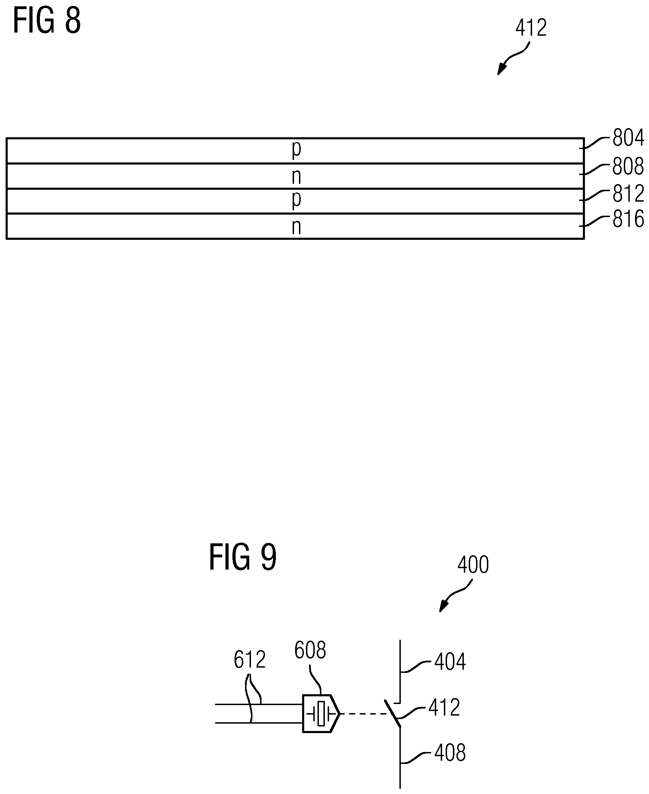

In Figur 8 ist schematisch ein beispielhafter möglicher Aufbau des Bauteils 412 in einer Schnittdarstellung dargestellt. Das Bauteil ist als eine Scheibe 412 aus monokristallinem oder polykristallinem Silizium ausgestaltet. Die Scheibe 412 weist vier unterschiedlich dotierte Schichten auf: eine erste p-Schicht 804, eine erste n-Schicht 808, eine zweite p-Schicht 812 und eine zweite n-Schicht 816. Dadurch weist die Scheibe 412 mehrere p-n-Übergänge auf: beispielsweise einen ersten p-n-Übergang zwischen der ersten p-Schicht 804 und der ersten n-Schicht 808 und einen zweiten p-n-Übergang zwischen der zweiten p-Schicht 812 und der ersten n-Schicht 808. Der erste p-n-Übergang ist dem zweiten p-n-Übergang entgegengesetzt gerichtet. Daher ist das Bauteil 412 (im nichtzerstörten Zustand) in der Lage, den elektrischen Strom in beiden Richtungen zu sperren. Im zerstörten Zustand des Bauteils 412 hingegen sind die p-n-Übergänge nicht mehr wirksam und der elektrische Strom kann in beiden Richtungen fließen.

Im Ausführungsbeispiel sind die p-n-Übergänge als flächige p-n-Übergänge ausgestaltet. Die p-n-Übergänge sind parallel zu dem ersten elektrischen Kontaktstück und/oder parallel zu dem zweiten elektrischen Kontaktstück ausgerichtet.

Das schematisch in Figur 8 dargestellte Bauteil 412 weist im Wesentlichen die Struktur eines Thyristors bzw. einer Vierschichtdiode (Shockley-Diode) auf. In einem anderen Ausführungsbeispiel kann dieses Bauteil 412 auch die Struktur einer einfachen Diode aufweisen. In diesem Fall würde das Bauteil 412 lediglich die erste p-Schicht 804 und die erste n-Schicht 808 aufweisen; es würde also nur ein p-n-Übergang in dem Bauteil 412 vorhanden sein. In diesem Fall könnte das Bauteil 412 den elektrischen Strom lediglich in einer Richtung sperren.

Optional kann das Bauteil 412 auch als ein elektrisch einschaltbares Halbleiterbauelement (insbesondere als ein Thyristor) ausgestaltet sein, dessen Steueranschluss (insbesondere dessen Gate-Anschluss) aus der Kurzschließeinrichtung 400 herausgeführt ist. Der Steueranschluss würde dann beispielsweise die zweite p-Schicht 812 kontaktieren. Dann kann das Halbleiterbauelement auch mittels seines Steueranschlusses (elektrisch) eingeschaltet werden. Dies ermöglicht es, die Kurzschließeinrichtung auf zwei verschiedene Arten einzuschalten: zum Einen mittels des Aktors 608, der das Bauteil mit einer mechanischen Kraft beaufschlagt, und zum Anderen mittels des Steueranschlusses des Halbleiterbauelements (insbesondere des Gate-Anschlusses des Thyristors). Der erste Fall führt zum einmaligen Einschalten der Kurzschließeinrichtung unter Zerstörung des Bauteils 412, wohingegen der zweite Fall ein reversibles Einschalten bzw. ein wiederholtes Einschalten der Kurzschließeinrichtung 400 ermöglicht. Das Bauteil kann also zusätzlich elektrisch reversibel schaltbar ausgeschaltet sein. Dadurch kann die Kurzschließeinrichtung 400 noch vielseitiger eingesetzt werden.

In Figur 9 ist symbolhaft ein Schaltsymbol für die Kurzschließeinrichtung 400 dargestellt. Es ist zu erkennen, dass die Kurzschließeinrichtung 400 im Wesentlichen einen piezoelektrisch betätigten Einschalter darstellt, der für eine einmalige Betätigung bzw. für ein einmaliges Einschalten vorgesehen ist (Einmal-Einschalter, Einmal-Kurzschließer).

Beim Überführen der Kurzschließeinrichtung von dem nichtkurzschließenden Zustand in den kurzschließenden Zustand läuft folgendes Verfahren ab:
Zunächst (vor dem Anlegen des Auslösesignals an den Aktor) wird von dem Bauteil ein elektrischer Stromfluss zwischen dem ersten Kontaktstück und dem zweiten Kontaktstück in mindestens einer Richtung gesperrt. Wenn das Auslösesignal an den Aktor angelegt wird, dass wird das Bauteil von dem Aktor mit einer mechanischen Kraft beaufschlagt. Durch die mechanische Kraft wird die Kristallstruktur des Bauteils zumindest teilweise (mechanisch) zerstört. Dadurch wird der elektrische Stromfluss zwischen dem ersten elektrischen Kontaktstück und dem zweiten elektrischen Kontaktstück in der ursprünglich gesperrten Richtung ermöglicht. Dies wird auch als Durchlegieren des Bauteils bezeichnet.

Die Kurzschließeinrichtung 400 kann auch als eine Bypass-Scheibenzelle bezeichnet werden. Die Kurzschließeinrichtung 400 stellt eine nichtpyrotechnisch betätigte Kurzschließeinrichtung bzw. einen nichtpyrotechnisch betätigten Bypass-Schalter dar. Die Kurzschließeinrichtung 400 kann in sehr kurzen Zeiten geschlossen werden, beispielsweise in Zeiten kleiner als einer Millisekunde. Dies ermöglicht es insbesondere, die Kurzschließeinrichtung 400 in Stromrichtern einzusetzen, um im Fehlerfall defekte Module des Stromrichters zu überbrücken. Durch die Überbrückung der defekten Module kann der Betriebsstrom des Stromrichters und damit der Betrieb des Stromrichters weiter aufrecht erhalten werden. Der Bypass-Schalter 400 (die Kurzschließeinrichtung 400) ist in der Lage, im kurzschließenden Zustand (im geschlossenen Zustand) den Betriebsstrom des Stromrichters bis zur nächsten Wartung sicher zu tragen und dadurch das defekte Modul sicher zu überbrücken (kurzzuschließen).

Es wurde eine elektrische Kurzschließeinrichtung sowie ein Verfahren zum Kurzschließen eines elektrischen Moduls beschrieben.

## Patentansprüche

1. Elektrische Kurzschließeinrichtung (400)
- mit einem ersten elektrischen Kontaktstück (404) und einem zweiten elektrischen Kontaktstück (408),
- und mit einem Bauteil (412) aus einem elektrisch halbleitenden kristallinen Material, das einen elektrischen Stromfluss zwischen dem ersten Kontaktstück (404) und dem zweiten Kontaktstück (408) in mindestens einer Richtung sperrt, **gekennzeichnet durch** einen Aktor (608), der dazu eingerichtet ist, auf ein elektrisches Auslösesignal (S) hin das Bauteil (412) mit einer mechanischen Kraft zu beaufschlagen und dadurch die Kristallstruktur des Bauteils (412) zumindest teilweise zu zerstören.

2. Kurzschließeinrichtung nach Anspruch 1,
**dadurch gekennzeichnet, dass**
- das Bauteil (412) zwischen dem ersten Kontaktstück (404) und dem zweiten Kontaktstück (408) angeordnet ist.

3. Kurzschließeinrichtung nach Anspruch 1 oder 2,
**dadurch gekennzeichnet, dass**
- die Kurzschließeinrichtung (400) als Scheibenzelle ausgestaltet ist.

4. Kurzschließeinrichtung nach einem der vorhergehenden Ansprüche,
**dadurch gekennzeichnet, dass**
- das erste Kontaktstück (404) eine erste Ausnehmung (604) aufweist, in der der Aktor (608) angeordnet ist.

5. Kurzschließeinrichtung nach Anspruch 4,
**dadurch gekennzeichnet, dass**
- das zweite Kontaktstück (408) eine zweite Ausnehmung (620) aufweist, die gegenüberliegend zur ersten Ausnehmung (604) angeordnet ist.

6. Kurzschließeinrichtung nach Anspruch 4 oder 5,
**dadurch gekennzeichnet, dass**
- das Bauteil (412) die erste Ausnehmung (604) von der zweiten Ausnehmung (620) trennt.

7. Kurzschließeinrichtung nach einem der vorhergehenden Ansprüche,
**dadurch gekennzeichnet, dass**
- das Bauteil (412) eine Scheibe ist.

8. Kurzschließeinrichtung nach einem der vorhergehenden Ansprüche,
**dadurch gekennzeichnet, dass**
- das Bauteil (412) mindestens einen p-n-Übergang, insbesondere zwei einander entgegengesetzt gerichtete p-n-Übergänge, aufweist.

9. Kurzschließeinrichtung nach Anspruch 8,
**dadurch gekennzeichnet, dass**
- der mindestens eine p-n-Übergang ein flächiger p-n-Übergang ist, der parallel zu dem ersten elektrischen Kontaktstück (404) und/oder parallel zu dem zweiten elektrischen Kontaktstück (408) ausgerichtet ist.

10. Kurzschließeinrichtung nach einem der vorhergehenden Ansprüche,
**dadurch gekennzeichnet, dass**
- der Aktor (608) ein Piezoaktor ist.

11. Stromrichter (1) mit einer Mehrzahl von zweipoligen Modulen (1_1 ... 6_n), welche elektrisch in Reihe geschaltet sind, bei dem jedem der Module jeweils eine elektrische Kurzschließeinrichtung (220, 320, 400) nach einem der Ansprüche 1 bis 10 zugeordnet ist.

12. Stromrichter nach Anspruch 11,
**dadurch gekennzeichnet, dass**
- der Stromrichter (1) ein modularer Multilevelstromrichter ist.

13. Verfahren zum Kurzschließen eines elektrischen zweipoligen Moduls (1_1 ... 6_n), wobei parallel zu dem Modul eine elektrische Kurzschließeinrichtung (400) geschaltet ist, die ein erstes elektrisches Kontaktstück (404), ein zweites elektrisches Kontaktstück (408) und ein Bauteil (412) aus einem elektrisch halbleitenden kristallinen Material aufweist, wobei bei dem Verfahren
- von dem Bauteil (412) zunächst ein elektrischer Stromfluss zwischen dem ersten Kontaktstück (404) und dem zweiten Kontaktstück (408) in mindestens einer Richtung gesperrt wird,
- auf ein elektrisches Auslösesignal (S) hin das Bauteil von einem Aktor (608) mit einer mechanischen Kraft beaufschlagt wird, und
- dadurch die Kristallstruktur des Bauteils (412) zumindest teilweise zerstört wird, wodurch der elektrische Stromfluss zwischen dem ersten elektrischen Kontaktstück (404) und dem zweiten elektrischen Kontaktstück (408) in der ursprünglich gesperrten Richtung ermöglicht wird.

14. Verfahren nach Anspruch 13,
**dadurch gekennzeichnet, dass**
- das elektrische Modul (1_1 ... 6_n) mindestens zwei elektronische Schaltelemente (202, 206) und einen elektrischen Energiespeicher (210) aufweist.

15. Verfahren nach Anspruch 13 oder 14,
**dadurch gekennzeichnet, dass**
- das elektrische Modul (1_1 ... 6_n) ein Modul eines modularen Multilevelstromrichters (1) ist.

16. Verfahren nach einem der Ansprüche 13 bis 15,
**dadurch gekennzeichnet, dass**
- das Bauteil (412) eine Scheibe ist.

17. Verfahren nach einem der Ansprüche 13 bis 16,
**dadurch gekennzeichnet, dass**
- der Aktor (608) ein Piezoaktor ist.

## Claims

1. Electric short-circuit device (400)
- with a first electric contact piece (404) and a second electric contact piece (408),
- and with a component (412) made of an electrically semiconducting crystalline material that blocks a flow of electric current between the first contact piece (404) and the second contact piece (408) in at least one direction, **characterized by** an actuator (608) that is designed to apply a mechanical force to the component (412) in response to an electric trigger signal (S) and thereby at least partly destroy the crystal structure of the component (412).

2. Short-circuit device according to Claim 1,
**characterized in that**
- the component (412) is arranged between the first contact piece (404) and the second contact piece (408).

3. Short-circuit device according to Claim 1 or 2, **characterized in that**
- the short-circuit device (400) is designed as a disk cell.

4. Short-circuit device according to one of the preceding claims, **characterized in that**
- the first contact piece (404) comprises a first recess (604) in which the actuator (608) is arranged.

5. Short-circuit device according to Claim 4,
**characterized in that**
- the second contact piece (408) comprises a second recess (620) that is arranged opposite the first recess (604).

6. Short-circuit device according to Claim 4 or 5, **characterized in that**
- the component (412) separates the first recess (604) from the second recess (620).

7. Short-circuit device according to one of the preceding claims, **characterized in that**
- the component (412) is a disk.

8. Short-circuit device according to one of the preceding claims, **characterized in that**
- the component (412) comprises at least one p-n junction, in particular two p-n junctions, aligned in opposite directions.

9. Short-circuit device according to Claim 8,
**characterized in that**
- the at least one p-n junction is a planar p-n junction that is aligned parallel to the first electric contact piece (404) and/or parallel to the second electric contact piece (408).

10. Short-circuit device according to one of the preceding claims,
**characterized in that**
- the actuator (608) is a piezo actuator.

11. Power converter (1) with a plurality of two-pole modules (1_1... 6_n) that are connected electrically in series, wherein a respective electric short-circuit device (220, 320, 400) according to one of Claims 1 to 10 is assigned to each of the modules.

12. Power converter according to Claim 11,
**characterized in that**
- the power converter (1) is a modular multilevel power converter.

13. Method for short-circuiting an electric two-pole module (1 1... 6_n), wherein an electric short-circuit device (400) that comprises a first electric contact piece (404), a second electric contact piece (408) and a component (412) made of an electrically semiconducting crystalline material is connected in parallel with the module, wherein in the method
- a flow of electric current between the first contact piece (404) and the second contact piece (408) is initially blocked by the component (412) in at least one direction,
- the component is subjected to a mechanical force by an actuator (608) in response to an electric trigger signal (S), and
- the crystal structure of the component (412) is thereby at least partly destroyed, as a result of which the flow of electric current between the first electric contact piece (404) and the second electric contact piece (408) in the originally blocked direction is enabled.

14. Method according to Claim 13,
**characterized in that**
- the electric module (1_1... 6_n) comprises at least two electronic switching elements (202, 206) and an electric energy store (210).

15. Method according to Claim 13 or 14,
**characterized in that**
- the electric module (1_1... 6_n) is a module of a modular multilevel power converter (1).

16. Method according to one of Claims 13 to 15,
**characterized in that**
- the component (412) is a disk.

17. Method according to one of Claims 13 to 16, **characterized in that**
- the actuator (608) is a piezo actuator.

## Revendications

1. Dispositif (400) de court-circuit électrique
- comprenant une première pièce (404) de contact électrique et une deuxième pièce (408) de contact électrique,
- et comprenant un composant (412) en un matériau cristallin semi-conducteur électriquement, qui bloque, dans au moins un sens, un flux de courant électrique entre la première pièce (404) de contact et la deuxième pièce (408) de contact,
**caractérisé par** un actionneur (608), qui est conçu pour, sur un signal (S) de déclenchement électrique, soumettre le composant (412) à une force mécanique et détruire ainsi, au moins en partie, la structure cristalline du composant (412).

2. Dispositif de court-circuit suivant la revendication 1, **caractérisé en ce que**
- le composant (412) est monté entre la première pièce (404) de contact et la deuxième pièce (408) de contact.

3. Dispositif de court-circuit suivant la revendication 1 ou 2,
**caractérisé en ce que**
- le dispositif (400) de court-circuit est conformé en cellule à tranche.

4. Dispositif de court-circuit suivant l'une des revendications précédentes,
**caractérisé en ce que**
- la première pièce (404) de contact a un premier évidement (604), dans lequel est disposé l'actionneur (608).

5. Dispositif de court-circuit suivant la revendication 4, **caractérisé en ce que**
- la deuxième pièce (408) de contact a un deuxième évidement (620), qui est disposé en face du premier évidement (604).

6. Dispositif de court-circuit suivant la revendication 4 ou 5,
**caractérisé en ce que**
- le composant (412) sépare le premier évidement (604) du deuxième évidement (620).

7. Dispositif de court-circuit suivant l'une des revendications précédentes,
**caractérisé en ce que**
- le composant (412) est une tranche.

8. Dispositif de court-circuit suivant l'une des revendications précédentes,
**caractérisé en ce que**
- le composant (412) a au moins une jonction p-n, notamment deux jonctions p-n, dirigées en sens contraires l'une par rapport à l'autre.

9. Dispositif de court-circuit suivant la revendication 8,
**caractérisé en ce que**
- la au moins une jonction p-n est une jonction p-n de surface, qui est dirigée parallèlement à la première pièce (404) de contact électrique et/ou parallèlement à la deuxième pièce (408) de contact électrique.

10. Dispositif de court-circuit suivant l'une des revendications précédentes,
**caractérisé en ce que**
- l'actionneur (608) est un actionneur piézoélectrique.

11. Convertisseur (1) ayant une pluralité de modules (1_1 ... 6_n) bipolaires, qui sont montés électriquement en série, dans lequel, à chacun des modules, est associé, respectivement, un dispositif (220, 320, 400) de court-circuit électrique suivant l'une des revendications 1 à 10.

12. Convertisseur suivant la revendication 11,
**caractérisé en ce que**
- le convertisseur (1) est un convertisseur modulaire à plusieurs niveaux.

13. Procédé pour court-circuiter un module (1_1 ... 6_n), électrique bipolaire, dans lequel il est monté en parallèle au module un dispositif (400) de court-circuit électrique, qui a une première pièce (404) de contact électrique, une deuxième pièce (408) de contact électrique et un composant (412) en un matériau cristallin semi-conducteur électriquement, dans lequel, dans le procédé
- on bloque au moins dans un premier sens, par le composant (412), d'abord un flux de courant électrique entre la première pièce (404) de contact et la deuxième pièce (408) de contact,
- sur un signal (S) de déclenchement électrique, on soumet le composant à une force mécanique par un actionneur (608), et
- on détruit ainsi, au moins en partie, la structure cristalline du composant (412), grâce à quoi le flux de courant électrique entre la première pièce (404) de contact électrique et la deuxième pièce (408) de contact électrique est rendu possible dans le sens bloqué à l'origine.

14. Procédé suivant la revendication 13,
**caractérisé en ce que**
- le module (1_1 ... 6_n) électrique a au moins deux éléments (202, 206) électroniques de coupure et un accumulateur (210) d'énergie électrique.

15. Procédé suivant la revendication 13 ou 14,
**caractérisé en ce que**
- le module (1_1 ... 6_n) électrique est un module d'un convertisseur (1) modulaire à plusieurs niveaux.

16. Procédé suivant l'une des revendications 13 à 15,
**caractérisé en ce que**
le composant (412) est une tranche.

17. Procédé suivant l'une des revendications 13 à 16,
**caractérisé en ce que**
l'actionneur (608) est un actionneur piézoélectrique.
